# EUROPEAN PATENT SPECIFICATION

(11) **EP 3 006 408 B1**
(45) Date of publication and mention of the grant of the patent: **27.03.2019**
(21) Application number: 14800253.8
(22) Date of filing: 22.05.2014
(51) Int. Cl.: C02F 1/48, H05H 1/24

(54) **METHODS AND DEVICE FOR PRODUCING BACTERICIDAL LIQUID**
VERFAHREN UND VORRICHTUNG ZUR HERSTELLUNG EINER BAKTERIZIDEN FLÜSSIGKEIT
PROCÉDÉS ET DISPOSITIF DE PRODUCTION DE LIQUIDE BACTÉRICIDE

(30) Priority: 24.05.2013 JP 2013109827
(43) Date of publication of application: 13.04.2016
(73) Proprietor: Osaka University, Suita-shi, Osaka 565-0871 (JP)
(72) Inventor: KITANO, Katsuhisa, Suita-shi Osaka 565-0871 (JP); IKAWA, Satoshi, Izumi-shi Osaka 594-1157 (JP); NAKASHIMA, Yoichi, Izumi-shi Osaka 594-1157 (JP)
(74) Representative: Haseltine Lake LLP
(86) International application number: PCT/JP2014/002704
(87) International publication number: WO 2014/188725

(56) References cited:
- EP-A1- 1 985 589
- WO-A1-03/022736
- WO-A1-2004/060817
- WO-A1-2004/060817
- JP-A- 2006 021 027
- JP-A- 2008 218 369
- JP-A- 2009 022 885
- JP-A- 2009 022 885
- JP-A- 2009 183 867
- JP-A- 2009 513 605
- US-A1- 2003 180 421
- LIU D X ET AL: "Global model of low-temperature atmospheric-pressure He + H2O plasmas", PLASMA SOURCES SCIENCE AND TECHNOLOGY, INSTITUTE OF PHYSICS PUBLISHING, BRISTOL, GB, vol. 19, no. 2, 1 April 2010 (2010-04-01), page 25018, XP020175565, ISSN: 0963-0252

## Description

### FIELD

The present invention relates to methods and to an apparatus for producing liquid for sterilization which is used to sterilize a living body, medical equipment, and so on.

### BACKGROUND

Low-temperature plasma generated under an atmospheric pressure has conventionally attracted attention in the medical field and other fields. Such plasma is sometimes called low-temperature plasma, atmospheric pressure plasma, atmospheric pressure low-temperature plasma, non-equilibrium plasma, Low Frequency (LF) plasma, or the like. An LF plasma jet which is an example of devices capable of generating such plasma is disclosed in WO2008/072390.

Application examples of such plasma include a technology for emitting plasma onto an object or a liquid such as water to purify or sterilize the object or the liquid (Japanese Unexamined Patent Application Publication Nos. 2009-22391, 2006-289236, 2010-523327, and 2012-96141).

There has been proposed a technology for supplying steam to a tube where an object to be sterilized is placed, and causing discharge by electrodes placed inside the tube to sterilize the object (Japanese Unexamined Patent Application Publication No. 2009-22391).

Another technology has been proposed in which plasma discharge is generated by two electrodes one of which is disposed above a water tank for reserving water therein and the other of which is disposed in the bottom of the water tank, thereby to obtain plasma discharge treated water having high ozone concentrations (Japanese Unexamined Patent Application Publication No. 2006-289236).

According to yet another technology, water containing germs is flown into a stepwise flow passage. The water flowing like a film is exposed to plasma to generate O radicals and OH radicals. The O radicals and OH radicals thus generated are used to completely sterilize the germs contained in the water.

Further, it has been known that an enhanced microbicidal activity by which the time required for sterilization is reduced to approximately one hundredth is obtained by emitting plasma onto a liquid of which a pH value has been lowered (WO2009/041049). In the odontotherapy field, for example, sterilization has been performed using chemical agents, which unfortunately has caused a postoperative infectious disease due to insufficient sterilization. In contrast, sterilization using pH adjustment in a liquid and using plasma provides a further sterilizing effect.
US 2003/180421A1 discloses a non-thermal plasma reactor for treating a liquid with non-thermal plasma species. The disclosed reactor includes a liquid inlet, a liquid outlet, a reaction volume between the liquid inlet and the liquid outlet and at least one non-thermal plasma electrode adjacent to the reaction volume. The non-thermal plasma electrode is isolated physically and electrically from the flow path by a dielectric barrier.
WO2004/060817A1 discloses a low-temperature pasteurization method which comprises exterminating a subject microorganism existing in water or an aqueous fluid by using hydrogen peroxide-origin radicals at a concentration ranging from 0.3 to 3.0% in the presence of visible rays at a temperature of from -20 to 10°C.

### SUMMARY

### TECHNICAL PROBLEM

However, in order to use plasma for odontotherapy, a plasma generation device should be installed in a place where a medical treatment is provided. Further, a pipe line for introducing atmospheric gases should be provided in order to generate plasma. According to circumstances, another pipe line is needed to discharge gases which are to be generated as a byproduct.

In the case of sterilizing and disinfecting medical equipment, it is necessary to install a plasma generation device in a clinical site and to secure necessary pipe lines.

In light of the foregoing, instead of using plasma to purify or sterilize an object or water directly, it is very useful to generate, in advance, a plasma-treated solution containing plasma therein, and to use the plasma-treated solution for sterilization at a time and location different from the time and location where the plasma-treated solution is generated.

The present invention has been achieved in light of such an issue, and therefore, an object of an embodiment of the present invention is to provide methods and an apparatus for continuously generating a plasma-treated solution using plasma in an efficient manner.

### SOLUTION TO PROBLEM

The invention is defined in the independent claims. Optional embodiments are set out in the dependent claims.

### ADVANTAGEOUS EFFECTS OF INVENTION

According to the present invention, it is possible to continuously generate a plasma-treated solution using plasma in an efficient manner.

### BRIEF DESCRIPTION OF DRAWINGS

Fig. 1 is a front view showing a structure of an apparatus for producing liquid for sterilization use according to a first embodiment of the present invention.
Fig. 2 is a cross-sectional view of the left side of the apparatus for producing liquid for sterilization use shown in Fig. 1.
Fig. 3 is an expanded sectional view of a pipe line.
Fig. 4 is a diagram showing an example of a piping structure for discharging water on an outlet side of a pipe line.
Fig. 5 is a diagram showing an example of a piping structure of a water supply pipe line, a gas pipe line, and a pipe line.
Fig. 6 is a graph showing the relationship between a lapse of a treated solution and biocidal activity.
Fig. 7 is a graph showing the relationship between a temperature of a treated solution and a half-life of active species.
Fig.8 is a chart showing the relationship between a temperature of a treated solution and an ultimate concentration of active species.
Fig. 9 is a graph showing the relationship between a temperature and a half-life of active species.
Fig. 10 is a graph showing the relationship between a freezing temperature of a treated solution and a sterilization effect.
Fig. 11 is a graph showing the relationship between a storage time of a treated solution and a microbicidal activity.
Fig. 12 is a graph showing the result of measurement of absorbance by a DPD reagent in a produced treated solution.
Fig. 13 is a diagram showing a structure of an apparatus for producing liquid for sterilization use according to a second embodiment of the present invention.
Fig. 14 is a diagram showing a structure of an apparatus for producing liquid for sterilization use according to a third embodiment of the present invention.
Fig. 15 is a cross-sectional view of the left side of the apparatus for producing liquid for sterilization use shown in Fig. 14.
Fig. 16 is a cross-sectional view of another type of a plasma treatment mechanism.
Fig. 17 is a diagram showing a structure of an apparatus for producing liquid for sterilization use according to a further embodiment of the present disclosure.
Fig. 18 is a flowchart depicting an example as to how a liquid for sterilization use is produced.

### DESCRIPTION OF EMBODIMENTS

### [Outline of Apparatus for Producing Liquid for Sterilization Use]

A method and device according to the present invention may be implemented as in various embodiments described below. The following embodiments are only examples and not limited to the embodiments presented.

An apparatus for producing liquid for sterilization use may be implemented as discussed below.

To be specific, in accordance with claim 1, the inventive apparatus includes a pipe line; a water supplying device for supplying the pipe line with water; a gas supplying device for supplying the pipe line with nitrogen gas; a plasma generation device having a high-voltage electrode and a ground electrode which are provided outside the pipe line to face each other with the pipe line interposed therebetween and applying a plasma treatment continuously to the water flowing in the pipe line by generating dielectric barrier discharge between the high-voltage electrode and the ground electrode; a cooling device for cooling the water flowing in the pipe line at a temperature of 10° C or lower; and a vessel for holding the water flowing out of the pipe line as the liquid for sterilization use.

The inventive apparatus includes furthermore a pH adjustment device for adjusting a pH value of the water.

In an optional embodiment of the present invention, the pipe line is provided to have an inclination with respect to a horizontal plane, and the water flows in the pipe line by gravity of the water due to inclination of the pipe line.

In another optional embodiment of the present invention, the pipe line is made of a dielectric material such as a quartz glass, and the plasma generation device is so arranged that the pipe line functions as a dielectric for the dielectric barrier discharge.

In another optional embodiment of the present invention, each of the high-voltage electrode and the ground electrode has a rectangular cross-section, is disposed along the pipe line, and has a width corresponding to a width of the pipe line. The high-voltage electrode is disposed above the pipe line, and the ground electrode is disposed below the pipe line.

In a further optional embodiment of the present invention, the cooling device has a cooling medium pipe line disposed to contact the high-voltage electrode and the ground electrode, and a cooling medium supplying device for supplying the cooling medium pipe line with a cooling medium.

In another further optional embodiment of the present invention, the pipe line has a circular cross-section and the inside the pipeline is filled with water, nitrogen gas and helium gas, such that no oxygen gas is substantially present in the pipeline.

In another optional embodiment of the present invention, the ground electrode is formed to have a hollow portion through which a cooling medium flows, and the ground electrode is a part of the cooling device.

For example, the pipe line is provided with a discharge gas supplying device for supplying the pipe lie with helium gas or argon gas.

In another optional embodiment of the present invention, the pipe line is provided to meander on a base inclinable to the horizontal plane, and a speed of the water flowing in the pipe line is adjusted by varying an inclination angle of the base with respect to the horizontal plane.

According to claim 9, a method for producing liquid for sterilization use may be implemented as discussed below.

To be specific, the method includes: supplying a pipe line with water and nitrogen gas; generating dielectric barrier discharge between a high-voltage electrode and a ground electrode which are provided outside the pipe line to face each other with the pipe line interposed therebetween while water flowing in the pipe line is cooled directly or indirectly by a cooling device, and continuously making plasma generated by the dielectric barrier discharge contact with the water flowing in the pipe line; and holding the water flowing out of the pipe line as the liquid for sterilization use.

Furthermore, according to the present invention, the water flowing in the pipeline is cooled to a temperature of 10° C or lower and the pH value of the water is adjusted such that the liquid for sterilisation purpose has a pH of 4.8 or lower.

In a further optional embodiment of the present invention, freezing-point depressant is added to water to be supplied to the pipe line to lower a freezing point of the water, and the water is cooled by the cooling device to become 0°C or lower but not to be frozen.

In the present invention, preferably, water to be supplied to the pipe line is adjusted in advance to have a pH value of 4.8 or lower.

Another inventive method for producing liquid for sterilization use may be implemented as defined in claim 13.

The description goes on to embodiments for the apparatus for producing liquid for sterilization use.

### [First Embodiment]

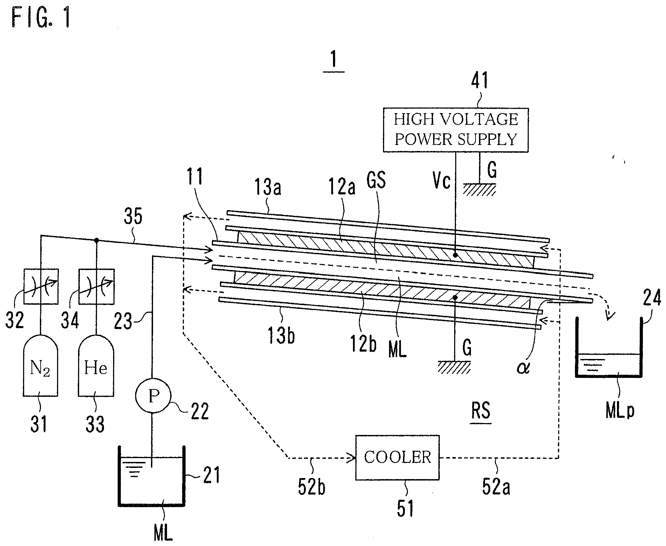

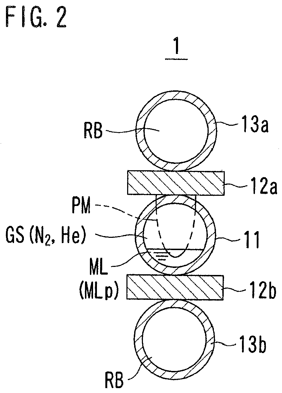

Fig. 1 schematically shows a structure of a sterilization liquid production apparatus 1 according to a first embodiment of the present invention. Fig. 2 is a cross-sectional view of the left side of the sterilization liquid production apparatus 1.

Referring to Figs. 1 and 2, the sterilization liquid production apparatus 1 is provided with a plasma treatment mechanism PK which includes a pipe line 11, a high-voltage electrode 12a, a ground electrode 12b, and cooling pipe lines 13a and 13b.

The sterilization liquid production apparatus 1 is also provided with a water vessel 21, a water pump 22, a water supply pipe line 23, a treated solution vessel 24, a nitrogen tank 31, a helium tank 33, flow controllers 32 and 34, a gas pipe line 35, a high voltage power supply 41, a cooler 51, cooling medium pipe lines 52a and 52b, and so on in order to supply the plasma treatment mechanism PK with a high voltage Vc, water ML, gases GS, cooling medium RB, and so on.

The pipe line 11 is made of a dielectric material to have a circular tube shape and a linear shape along the length direction of the pipe line 11. In this embodiment, the pipe line 11 is made of a quartz glass. Instead of this, however, the pipe line 11 may be made of another dielectric material such as various types of resin, ceramics, or barium titanate.

The pipe line 11 may be set to have a diameter (external diameter) of, for example, approximately a few millimeters through a dozen millimeters, in particular, for example, 6 through 10 millimeters, more specifically, approximately 10 millimeters, for example. If the pipe line 11 has a thickness of, for example, 1 millimeter, then the pipe line 11 has an internal diameter of, for example, 4 through 8 millimeters. The pipe line 11 may be set to have a length of, for example, several tens of centimeters through a few meters, specifically, approximately 1 meter, for example.

The pipe line 11 is disposed at an angle of α relative to the horizontal plane so that the water ML flows therein by gravity. To be specific, the water ML flows, as a free stream, inside the pipe line 11 at an almost constant speed not by another pressure but only by gravity of the water ML due to the inclination of the pipe line 11. In some cases, however, the flow of the water ML is slightly influenced by a pressure of gases GS in the pipe line 11.

The water ML flows only in a part of the bottom of the pipe line 11, and does not flow so as to fill the entirety of the cross-sectional surface of the pipe line 11.

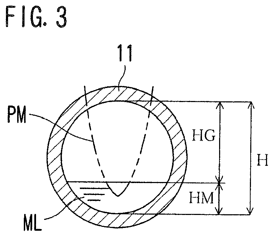

Referring also to Fig. 3, in the pipe line 11 having a height (internal diameter) H of an effective cross-sectional surface of the flow passage, the water ML flows in a space having a height HM from the bottom of the pipe line 11. A space between the surface of the water ML and the top of the pipe line 11 has a height of HG. The space is filled with gases GS such as nitrogen (N₂) and helium (He) as described later. Stated differently, the inside of the pipe line 11 is filled with the water ML, the nitrogen gas, and the helium gas, and no oxygen gas is present substantially.

It is preferable that the level HG of the water ML falls within a range of approximately one-fifth through half of the height H of the pipe line 11. The larger the surface area of the water ML with respect to the volume thereof is, the easier active species by the plasma make contact with the water ML, which enables the active species to easily diffuse into the water ML. The water ML has a maximum surface area for the case where the level HG of the water ML is equal to a half of the height H of the pipe line 11. The surface area of the water ML is reduced as the water ML is further increased. The flow rate is reduced for the case where the level HG of the water ML is excessively low, which reduces production of treated solution MLp.

In order to allow the water ML to flow easily in the pipe line 11, a hydrophilic treatment using titanium oxide may be applied to the inner wall of the pipe line 11. In such a case, it is preferable to apply the hydrophilic treatment so as not to influence the active species generated by the plasma PM. Alternatively, before the water ML flows in the pipe line 11, discharge is generated, and the inner wall is exposed to the discharge. Thereby, the hydrophilic treatment may be applied.

Each of the high-voltage electrode 12a and the ground electrode 12b is made of a metallic material such as copper or aluminium and is formed to have a long bar shape. Each of the high-voltage electrode 12a and the ground electrode 12b has a rectangular cross-section. In other words, each of the high-voltage electrode 12a and the ground electrode 12b has a plate-like shape or square bar shape, and has a width which is equivalent to a width of the flow passage of the pipe line 11.

The high-voltage electrode 12a and the ground electrode 12b are disposed outside and along the pipe line 11. The high-voltage electrode 12a and the ground electrode 12b are disposed to face each other with the pipe line 11 interposed therebetween. To be specific, the high-voltage electrode 12a is disposed to contact an upper part of the pipe line 11, and the ground electrode 12b is disposed to contact a lower part of the pipe line 11. Disposing the ground electrode 12b in a lower part of the pipe line 11 makes it easy to install the plasma treatment mechanism PK. Instead of this, however, the ground electrode 12b may be disposed in an upper part of the pipe line 11 and the high-voltage electrode 12a may be disposed in a lower part thereof.

The high voltage power supply 41, described later, applies a high voltage between the high-voltage electrode 12a and the ground electrode 12b. This causes dielectric barrier discharge between the high-voltage electrode 12a and the ground electrode 12b. Plasma PM is generated by the dielectric barrier discharge. The plasma PM makes contact with the water ML flowing in the pipe line 11, so that a plasma treatment is applied to the water ML.

Each of the cooling pipe lines 13a and 13b is made of a metallic material having a good thermal conductivity. Each of the cooling pipe lines 13a and 13b is made to have a tubular shape. The cooling medium RB flows in each of the cooling pipe lines 13a and 13b. The cooling medium RB flows in a direction opposite to the direction of the flow of the water ML. In short, the water ML to be cooled flows in a direction opposite to the direction of the flow of the cooling medium RB.

Examples of the cooling medium RB are water, ice water (water cooled by ice cubes), water of which a freezing point is lowered by freezing-point depressant, and cooling medium gas such as fluorocarbon and ammonia. The cooling pipe lines 13a and 13b contact the high-voltage electrode 12a and the ground electrode 12b respectively so as to cool the high-voltage electrode 12a and the ground electrode 12b and to cool the water ML indirectly via the pipe line 11.

In order to bundle and retain the pipe line 11, the high-voltage electrode 12a, the ground electrode 12b, the cooling pipe lines 13a and 13b, a suitable holding device (not shown) is used. The holding device is provided with a frame member which surrounds all of the pipe line 11, the high-voltage electrode 12a, the ground electrode 12b, and the cooling pipe lines 13a and 13b. The holding device is so structured that a screw member or an elastic member applies pressure from above or below to make the pipe line 11, the high-voltage electrode 12a, the ground electrode 12b, and the cooling pipe lines 13a and 13b contact with one another. Such holding members may be placed at positions in the longitudinal direction of the plasma treatment mechanism PK. The holding members may be so structured to make an inclination angle a with respect to the plasma treatment mechanism PK including the pipe line 11.

Alternatively, it is possible to hold the plasma treatment mechanism PK together by winding the plasma treatment mechanism PK with an appropriate adhesive tape, Kapton (registered trademark) tape, or the like. Yet alternatively, it is possible to hold the plasma treatment mechanism PK together with a heat shrinkable tube.

The water vessel 21 contains the water ML therein. The water ML may be pure water, ultrapure water, or tap water. The water ML may be a liquid of which a pH value has been lowered by adding an acid liquid such as acetic acid (CHCOOH) or citric acid (C6H8O7) to the pure water, the ultrapure water, or the tap water. The water ML may be a liquid to which, as freezing-point depressant, salt such as calcium chloride (CaCl2) or sodium chloride (NaCl) is added to the pure water, the ultrapure water, or the tap water. The water ML may be physiological saline, another liquid, or an aqueous solution.

The plasma treatment lowers a pH value of the water ML; however, in terms of life time of biocidal activity in the treated solution MLp, it is preferable to make a pH value of the water ML as low as possible, as described later. For example, the water ML is adjusted in advance to have a pH value of 4.8 or lower. The pH value of the water ML may be adjusted to become 4.5 or lower, more preferably to become 2 or so. In practical use, the pH value of the water ML may be adjusted to become 3 or lower.

The water pump 22 pumps the water ML contained in the water vessel 21 at a predetermined flow rate, and supplies the water ML through the water supply pipe line 23 to the inlet side (the upstream side) of the pipe line 11. The water pump 22 may be a pump which is driven, for example, by a motor and of which a discharge amount is adjusted by controlling the speed of the motor. The water pump 22 may be PERISTA PUMP sold by ATTO products.

The amount of the water ML to be supplied to the pipe line 11 by the water pump 22 may be, for example, an amount falling within the range of approximately a few tenths of a milliliter through a few milliliters per minute, more specifically, may be, for example, an amount falling within the range of approximately 0.3 through 3.0 milliliters per minute, and, more concretely, may be, for example, approximately 2 milliliters per minute.

The treated solution vessel 24 receives the water ML flowing from the pipe line 11 to hold the water ML as the treated solution MLp. The treated solution MLp produced in the foregoing manner is an example of the "liquid for sterilization use" recited in the present invention. The treated solution vessel 24 is desirably cooled by a cooling device (not shown) and the like to be kept at a low temperature.

For example, the treated solution vessel 24 is formed by using a metallic material and is placed on a base. The cooling medium pipe line 52a is provided to pass through the base, so that the base is cooled. The cooled base then cools the treated solution vessel 24.

In order that the treated solution vessel 24 certainly receives the water ML flowing from the pipe line 11, it is possible to fix an appropriate piping member such as an elbow at the flow outlet (the downstream end) of the pipe line 11.

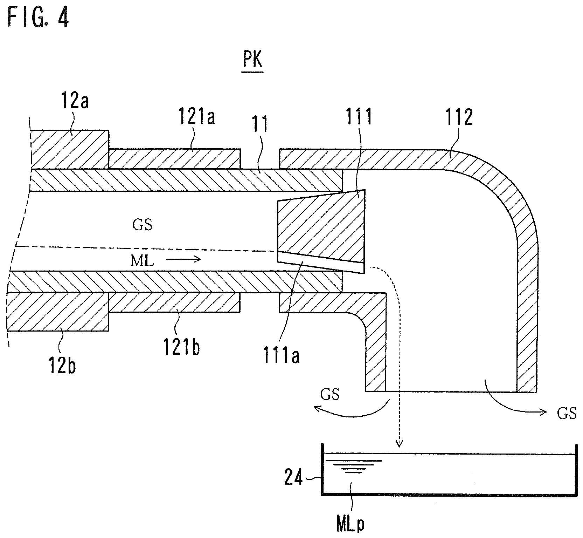

Fig. 4 shows an example of a piping structure for discharging the water ML on the outlet side of the pipe line 11.

Referring to Fig. 4, a stopper 111 which is made of soft resin such as silicone rubber is provided in the flow outlet of the pipe line 11. The stopper 111 has a groove 111a along the axis direction thereof on a part of the periphery of the stopper 111. The stopper 111 is so inserted that the groove 111a faces the lower surface of the pipe line 11. The pipe line 11 is connected to an elbow 112 which allows the flow outlet faces downward. The treated solution vessel 24 is placed below the flow outlet of the elbow 112. The water ML flowing through the pipe line 11 passes through the groove 111a to fall (drop) from the flow outlet of the elbow 112. The gases GS supplied into the pipe line 11 partly passes through the groove 111a and are discharged from the flow outlet of the elbow 112 to the atmosphere.

The water ML flows, in the pipe line 11, at a speed depending on the inclination angle α of the pipe line 11, and passes through the groove 111a to flow smoothly from the flow outlet. The water pump 22 supplies the water ML to replenish the amount corresponding to the water ML flowing from the flow outlet.

The stopper 111, the groove 111a, and the elbow 112 may be integrally formed, for example, with synthetic resin.

In the case where the flow outlet of the pipe line 11 has to be drawn from the high-voltage electrode 12a and the ground electrode 12b, auxiliary electrodes 121a and 121b shown in Fig. 4 are provided in the drawn part so that dielectric barrier discharge is generated between the auxiliary electrodes 121a and 121b. Owing to the auxiliary electrodes 121a and 121b, the plasma treatment is efficiently applied to the water ML in the pipe line 11. The auxiliary electrodes 121a and 121b may be implemented by using a conductive tape, a copper foil, or a copper plate, for example, to attach the same to the surface of the pipe line 11. It is preferable that the auxiliary electrode 121a and the auxiliary electrode 121b are connected to the high-voltage electrode 12a and the ground electrode 12b, respectively.

As the treated solution vessel 24, or, instead of the treated solution vessel 24, a device may be used which receives the treated solution MLp and carries the treated solution MLp continuously to another location. Alternatively, a device may be used which receives the treated solution MLp and instantly fills and packs a predetermined amount of the treated solution MLp into an appropriate case in real time. Yet alternatively, a device may be used which receives the treated solution MLp, freezes the treated solution MLp rapidly, and makes solid ice blocks (frozen ice blocks) each of which has a predetermined amount.

The nitrogen tank 31 contains, as liquid nitrogen or high-pressure nitrogen for example, nitrogen which is a gas for generating active species. The helium tank 33 contains, as liquid helium or high-pressure helium for example, helium which is a gas for generating plasma (discharge). The flow controllers 32 and 34 adjust flow rates of the gases GS to reach the set flow rates. An example of the flow controllers 32 and 34 is a mass flow controller sold by KOFLOC Co., Ltd.

The flow rates of the gases GS supplied from the nitrogen tank 31 and the helium tank 33 are adjusted by the flow controllers 32 and 34. After that, the gases GS are mixed in the gas pipe line 35 and the resultant is supplied to the inlet side of the pipe line 11. The gas pipe line 35 and the pipe line 11 are connected to each other by, for example, a piping member to prevent outside leakage of the gases GS.

For example, output sides of the flow controllers 32 and 34 are formed to join together by using a tee-piece or an appropriate manifold to be provided as one gas pipe line 35, and the resultant is connected to the inlet side of the pipe line 11. The end of the gas pipe line 35 is connected to the pipe line 11 by using a tee-piece or an appropriate manifold, and the end of the water supply pipe line 23 is connected to the pipe line 11. This enables the water ML and the gases GS to be supplied to the pipe line 11 concurrently.

The nitrogen tank 31, the flow controller 32, the gas pipe line 35, and so on are examples of the "gas supplying device" recited in the present invention. The helium tank 33, the flow controller 34, the gas pipe line 35, and so on are examples of the "discharge gas supplying device" recited in the present invention. In this embodiment, the nitrogen gas (approximately 1 %) is mixed with the helium gas in the gas pipe line 35. Only nitrogen is used as the gas for generating active species, and no oxygen is used. Stated differently, since no oxygen gas is supplied to the pipe line 11, no oxygen is present substantially inside the pipe line 11.

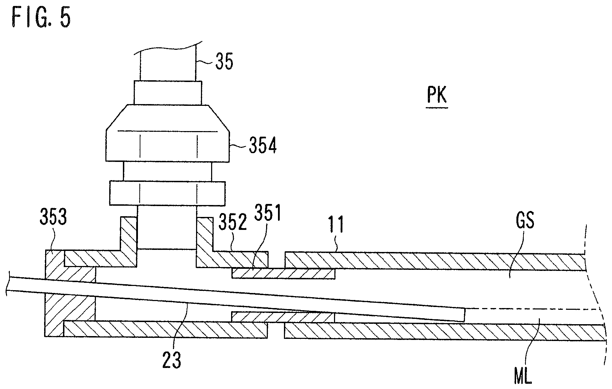

Fig. 5 shows an example of a piping structure of the water supply pipe line 23, the gas pipe line 35, and the pipe line 11.

Referring to Fig. 5, a tee-piece 352 is connected to the flow inlet of the pipe line 11 through a nipple 351. The tee-piece 352 has one opening into which a plug 353 having seal properties is inserted. The water supply pipe line 23 made of a resin tube or the like penetrates through a hole provided therein, and reaches into the pipe line 11. The space between the plug 353 and the water supply pipe line 23 is sealed.

The tee-piece 352 has another opening connected to a joint nipple 354. The joint nipple 354 has, for example, a tube insertion portion. The joint nipple 354 tightens, by means of a sleeve and a cap nut, the gas pipe line 35 which is made of a resin tube and is inserted into the tube insertion portion, and fixes the gas pipe line 35 to the tube insertion portion.

The flow rate of the nitrogen to be supplied to the pipe line 11 may be, for example, a value falling within the range of approximately several tens of milliliters through a hundred and several tens of milliliters per minute, more specifically, may be, for example, approximately 50 milliliters per minute. The flow rate of the helium to be supplied to the pipe line 11 may be, for example, a value falling within the range of approximately several hundreds of milliliters through a thousand and several hundreds of milliliters per minutes, more specifically, may be, for example, approximately 500 milliliters per minute or approximately 1000 milliliters per minute.

The pressure of the gases GS in the pipe line 11 is almost atmospheric pressure.

The helium gas is used in this embodiment; however argon gas may be used. The dielectric barrier discharge can be generated without the helium gas by increasing an electric field by increasing the high voltage Vc described below. Therefore, a gas for discharge such as the helium gas is not always necessary as long as the dielectric barrier discharge is generated.

The high voltage power supply 41 produces a pulse train of the high voltage Vc having a predetermined frequency. The high voltage Vc has a voltage value of, for example, approximately 10kV and a frequency of, for example, approximately 10kHz. The voltage value and the frequency of the high voltage Vc may be values different from those above.

The high voltage Vc temporally changing is applied between the high-voltage electrode 12a and the ground electrode 12b, so that dielectric barrier discharge is generated in the pipe line 11. At this time, the pipe line 11 itself functions as a dielectric in the dielectric barrier discharge. The plasma PM generated by the dielectric barrier discharge in the pipe line 11 makes contact with the water ML, so that plasma treatment is applied to the water ML.

To be specific, the plasma PM generated by the dielectric barrier discharge causes active species to be generated. The active species make contact with the water ML and are diffused in the water ML. As the active species, in particular, superoxide anion radicals (O₂⁻•) and the derivative (or precursor) thereof are important. The active species are diffused in the water ML, so that the water ML turns into the treated solution MLp.

The treated solution MLp has a microbicidal activity and the microbicidal activity is sustained. The microbicidal activity of the treated solution MLp is associated with acid dissociation equilibrium of the superoxide anion radicals. To be specific, the superoxide anion radicals and the derivative (or precursor) thereof exist in the treated solution MLp. The derivative generates the superoxide anion radicals gradually, so that the biocidal activity is sustained.

As a method for bringing the active species into contact with the water ML, it is preferable to emit the plasma PM to the water ML in a manner to make direct contact therewith. Even when the plasma PM does not make direct contact with the water ML, the active species may be electrophoresed to make the plasma PM contact with the water ML. In such a case, an electric field is created which is directed from the ground electrode 12b toward the high-voltage electrode 12a. The active species which are minus ions move toward the water ML by the electric field.

In order to enhance a sterilization effect in the treated solution MLp, it is necessary to adjust the treated solution MLp to have a pH value of 4.8 or lower before the treated solution MLp is applied to an object. The pH value of the treated solution MLp may be adjusted to become 4.8 or lower at a time point when the treated solution MLp is held in the treated solution vessel 24. Alternatively, the pH value of the treated solution MLp may be adjusted to become 4.8 or lower at a time point when the treated solution MLp is used to sterilize the object. Yet alternatively, the pH value of the water ML contained in the water vessel 21 may be adjusted in advance to become 4.8 or lower. The pH value of the treated solution MLp may be adjusted to become 4.5 or lower.

In order to adjust the pH value of the treated solution MLp in the foregoing manner, a pH adjustment device having an appropriate structure is used. In order to adjust the pH value by using the pH adjustment device, there are provided: a method of charging acid, or salt that indicates acidity into the water ML or the treated solution MLp; a method of blowing a carbonic acid gas into the water ML or the treated solution MLp; and so on. For example, acidic liquid such as citric acid or acetic acid used in food is preferably charged into the water ML or the treated solution MLp. In this way, when the pH value is adjusted to make the water ML or the treated solution MLp acidic, protons (hydrogen ions) H⁺ in the water ML increase.

The cooler 51 is an example of the "cooling medium supplying device" recited in the present invention. The cooler 51 is operable to supply the cooling medium RB having a cooling capability to the cooling medium pipe line 52a, and circulates the cooling medium RB into the cooling pipe lines 13a and 13b; thereby the water ML in the pipe line 11 is cooled through the high-voltage electrode 12a and the ground electrode 12b.

As described earlier, the appropriate base is used to cool the treated solution vessel 24 and the treated solution MLp. The cooling medium pipe line 52b may be used to cool the water vessel 21 and the water supply pipe line 23; thereby to cool the water ML to be supplied to the pipe line 11 in advance.

The cooler 51 may be a device for implementing a refrigeration cycle, for example, a compressor. In such a case, the cooling medium RB may be a cooling medium gas such as fluorocarbon or ammonia. The cooler 51 may be an ice machine or produced ice cubes. In such a case, ice water, water of which a freezing point has been lowered by the freezing-point depressant, or another aqueous solution is used as the cooling medium RB and is pumped by the pump.

The cooler 51, and the cooling medium pipe lines 52a and 52b constitute a cooling device RS.

The cooling device RS is capable of cooling the water ML of which a temperature rises due to the plasma PM to approximately a room temperature, to 20°C or lower, or to approximately 2°C. Depending on the cooling medium RB to be used, the temperature of the water ML may be lowered to a temperature immediately before a temperature at which the water ML is frozen. When normal water is used as the water ML, the temperature thereof may be lowered to 0°C or so. When water of which a freezing point has been lowered is used as the water ML, the temperature thereof may be lowered to a temperature in the vicinity of the freezing point.

For example, the water ML of which the freezing point has been lowered by the freezing-point depressant is cooled to become 0°C or lower but not to be frozen. For example, the water ML to which alcohol is added is cooled, in the form of liquid, to approximately -20°C, and then the plasma treatment is applied to the resultant. The temperature of the water ML and the treated solution MLp is kept as low as possible. This enables the treated solution MLp having a high concentration of active species to be generated, and also extends a life time of the biocidal activity.

As described earlier, the treated solution MLp in which the active species are diffused has biocidal activity. The biocidal activity of the treated solution MLp is, however, gradually lost as time advances. As the experiments proceed, it is found that, in order to produce the treated solution MLp and to prolong the biocidal activity of the treated solution MLp, lowering the temperature of the plasma-treated solution MLp is important.

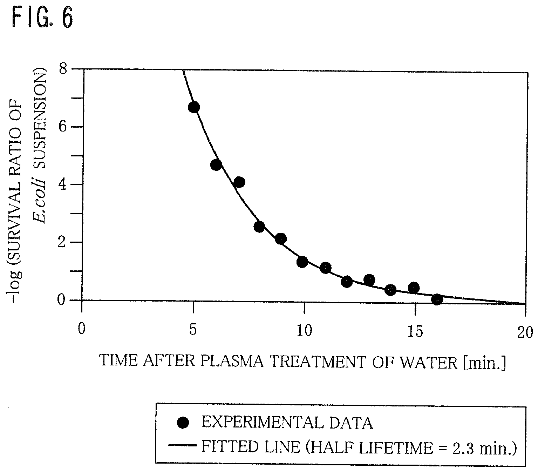

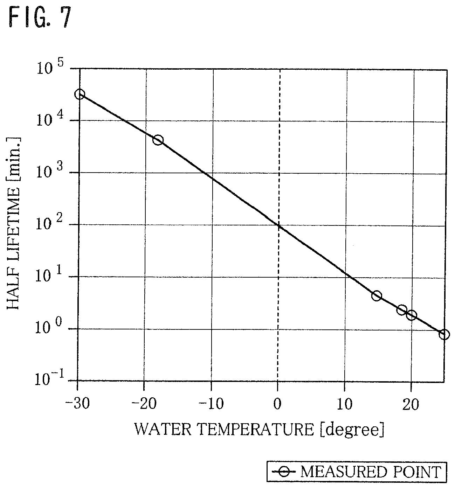

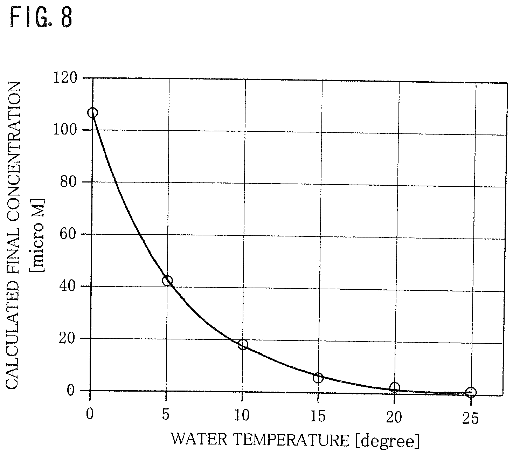

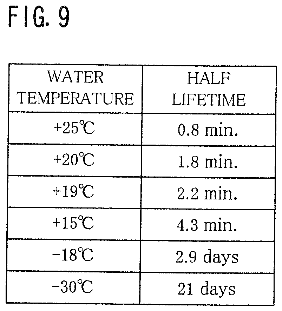

To be specific, Fig. 6 shows the relationship between a lapse of the treated solution MLp and the biocidal activity; Fig. 7 shows the relationship between a temperature of the treated solution MLp and a half-life of the active species; Fig. 9 shows the relationship between a temperature and a half-life of the active species; and Fig. 8 shows the relationship between a temperature of the treated solution MLp and an ultimate concentration of the active species.

As shown in Fig. 6, the biocidal activity decreases exponentially with time since the production of the treated solution MLp. Fig. 7 shows the temperature dependence of the half-life for sterilization characteristics obtained by calculating a half-life of the biocidal activity species based on the time variation in the biocidal activity shown in Fig. 6 and adjusting temperatures of the individual experimental systems.

As indicated in Figs. 7 and 8, when the temperature [°C] of the treated solution MLp is 25, 20, 19, 15, -18, and -30, the half-life of active species is 0.8 minutes, 1.91 minutes, 2.2 minutes, 4.3 minutes, 2.9 days, and 21 days, respectively.

Fig. 7 shows that the half-life for the biocidal activity increases approximately linearly by lowering the temperature of the treated solution MLp. This reflects the Arrhenius equation in which a logarithm of reaction rate is proportional to a temperature.

As known from Fig. 7, when the temperature is lowered to 10°C or so, the half-life reaches approximately 10 minutes. Consequently, a practical time is secured for the case where sterilization treatment using the treated solution MLp is carried out.

Lowering the temperature of the treated solution MLp increases the half-life of the active species. Therefore, even if a constant amount of active species are supplied by plasma per unit time, a final reached concentration of the active species changes. To be specific, for a short half-life, the active species disappear rapidly while being supplied. Accordingly, it is difficult to observe the increase in concentration. Fig. 8 shows the calculation result of dependence of ultimate concentration of active species on temperature.

In Fig. 9, the supply amount of w of active species per unit time is set at 1 µM/min. If the temperature (°C) of the treated solution MLp is 25, 20, 15, 10, 5, and 0, the final reached concentration (µM) of active species are 1.2, 2.8, 6.3, 18.8, 43.1, and 107, respectively.

As shown in Fig. 9, the ultimate concentration increases exponentially as the temperature drops. Therefore, the treated solution MLp having a high concentration of active species is obtained by lowering the temperature of the treated solution MLp or the temperature of the water ML flowing in the pipe line 11.

As known from the above, the time from when the treated solution MLp is generated until when the treated solution MLp is applied to an object is preferably as short as possible. For example, in a room temperature of approximately 25°C, it is possible to carry out sufficient sterilization treatment by applying the treated solution MLp to an object within 1 minute or so from the generation of the plasma-treated solution MLp.

When the temperature of the water ML or the treated solution MLp is set at 10°C or lower, it is possible to secure the time necessary to apply the treated solution MLp to carry out sterilization treatment. In other words, for generating and storing the treated solution MLp, it is important to keep the temperature of the water ML and the treated solution MLp as low as possible.

For the purpose of cooling the water ML or the treated solution MLp to have a low temperature of 10°C or lower and keeping the low temperature, the cooling device RS described above is used.

In order to store the treated solution MLp for a further longer period of time, it has been known that the treated solution MLp is preferably frozen to solid ice, and the solid ice is preferably frozen and stored at a temperature of -18°C or lower, further, at a temperature of -30°C or lower.

The description goes on to results of experiments conducted on biocidal activities of the treated solution MLp and the solid ice thereof.

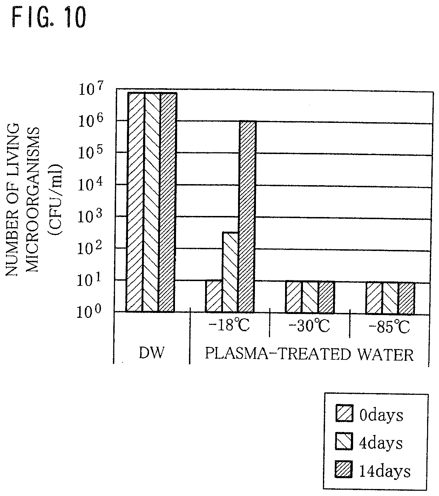

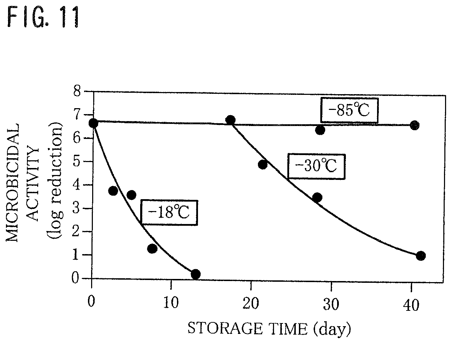

Fig. 10 shows the relationship between a freezing temperature of the treated solution MLp and a sterilization effect; and Fig. 11 shows the relationship between a storage time of the treated solution MLp and a microbicidal activity.

For the experiment, the treated solution MLp is frozen rapidly to produce solid ice blocks. The solid ice blocks are frozen and stored at a temperature of -18°C, - 30°C, and -85°C, respectively. After a predetermined lapse of time, the frozen solid ice blocks are thawed on ice to mix with a set of microbial suspension buffer solution. The mixture is left as-is at a room temperature for 5 minutes, serially diluted, applied onto a plate, and measured for the number of colonies.

According to the graphs of Figs. 10 and 11, in the case where the frozen treated solution is stored at -18°C, the microbicidal activity decreases gradually with time, and almost no biocidal activity is observed in two weeks.

In contrast, in the case where the frozen treated solution is stored at -30°C or lower, the biocidal activity still remains high even two weeks later.

As known from the experiment results, it is possible to transport and store the treated solution MLp with the biocidal activity maintained by rapidly freezing the treated solution MLp and storing the same at -30°C or lower.

### [Experimental Example 1]

An experiment of producing the treated solution MLp was made by means of a test model of the sterilization liquid production apparatus 1.

In the test model, the pipe line 11 has an external diameter of 10 millimeters, an internal diameter of 8 millimeters, and a length of approximately 1 meter. The flow rate of the treated solution MLp flowing from the flow outlet of the pipe line 11 is set at approximately 2 milliliters per minute. The discharge flow rate from the water pump 22 is set at approximately 2 milliliters per minute. In such a case, the flow rate of the water ML in the pipe line 11 is approximately 2 milliliters per minute. A period of time Tp for the water ML to be present in the pipe line 11, namely, the period of time Tp for the water ML to be exposed to the plasma PM is set at, approximately 2 minutes.

In the cooler 51, water cooled by ice blocks are pumped out by the pump. The ice water is supplied, as cooling water, from the cooling medium pipe line 52a to the cooling pipe lines 13a and 13b and is flown therein.

A DPD reagent is used to measure the concentration of biocidal activity species of the treated solution MLp produced. For comparison, such a measurement is similarly made on the treated solution MLp which is produced with no cooling water flown.

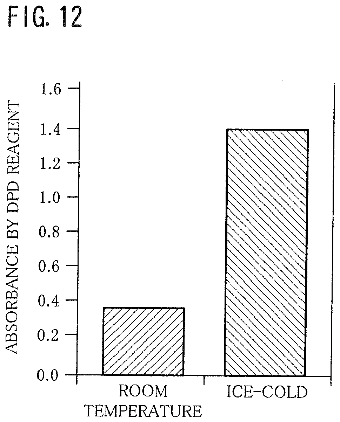

Fig. 12 shows the result of measurement of absorbance by the DPD reagent in the treated solution MLp produced.

Referring to Fig. 12, the absorbance is approximately 3.5 with no cooling water supplied. In contrast, the absorbance is approximately 14 with ice water supplied, and the treated solution MLp having a fourfold high concentration is produced. This shows microbicidal activity which sterilizes a fungus liquid of 10⁷ cfu/ml even when the treated solution MLp is diluted dozens of times.

The absorbance described herein is a value obtained by dividing the absorbance measured on the diluted treated solution MLp by the dilution ratio to convert the resultant into a value corresponding to the undiluted solution. In general, a measurement for absorbance can be made only up to 4 or so. For the convenience of experiment, a measurement is necessary after the treated solution MLp is diluted by using ultrapure water. For standardization, the absorbance measured by the measurement device is converted from the dilution ratio to the value corresponding to the undiluted solution.

In the experiment, when ice water is supplied from the cooler 51, the temperature of each of the inlets of the cooling pipe lines 13a and 13b is 0(zero) °C, the temperature of each of the outlets thereof is 2°C, and the temperature of the treated solution MLp produced is 16-17°C. When no cooling water is supplied, the temperature of the treated solution MLp produced is 29-32°C.

In the experiment, when water having a room temperature (20°C) is used as the cooling water, the temperature of each of the inlets of the cooling pipe lines 13a and 13b is 20°C, the temperature of each of the outlets thereof is 21°C, and the temperature of the treated solution MLp produced is 25-26°C.

As described above, the concentration of the biocidal activity species is greatly improved by cooling the water ML flowing in the pipe line 11 to a further lower temperature.

### [Second embodiment]

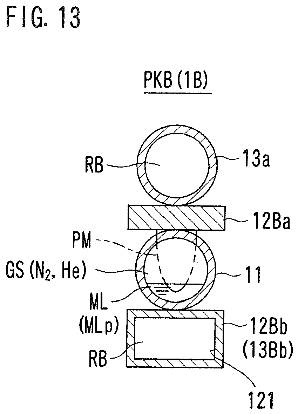

Fig. 13 schematically shows a structure of a plasma treatment mechanism PKB of a sterilization liquid production apparatus 1B according to the second embodiment of the present invention.

Referring to Fig 13, in the sterilization liquid production apparatus 1B, a ground electrode 12Bb functions also as a cooling pipe line 13Bb. To be specific, the ground electrode 12Bb is formed to have a hollow portion 121 through which a cooling medium flows, and the cooling medium RB flows through the hollow portion 121. Therefore, the ground electrode 12Bb is a part of the cooling device RS.

The ground electrode 12Bb is formed to have a rectangular shape which allows the dielectric barrier discharge to spread as widely as possible in the pipe line 11. However, the shape is not limited thereto. The ground electrode 12Bb may have another shape such as a half circular shape, circular shape, and elliptical shape as long as the dielectric barrier discharge spreads sufficiently in the pipe line 11.

The structures and functions of the other parts of the sterilization liquid production apparatus 1B according to the second embodiment are similar to those of the sterilization liquid production apparatus 1 according to the first embodiment. Accordingly, description of the points common to the first embodiment shall be omitted.

According to the plasma treatment mechanism PKB of the second embodiment, the ground electrode 12Bb functions also as the cooling pipe line 13Bb. This simplifies the structure and improves the cooling effect because the ground electrode 12Bb cools the pipe line 11 directly.

As with the ground electrode 12Bb, the high-voltage electrode 12Ba may function also as a cooling pipe line.

### [Third Embodiment]

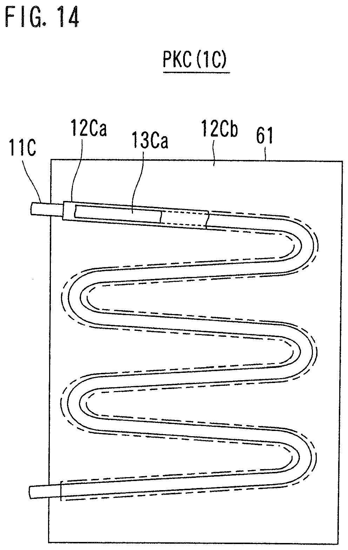

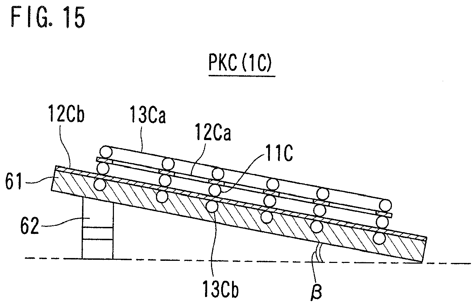

Figs. 14 and 15 show a structure of a plasma treatment mechanism PKC of a sterilization liquid production apparatus 1C according to the third embodiment of the present invention.

With the plasma treatment mechanism PKC shown in Figs. 14 and 15, a pipe line 11C is provided on a base 61 which is inclinable to the horizontal plane. The pipe line 11C meanders on the base 61. The speed of water flowing in the pipe line 11C is adjusted by varying an inclination angle β of the base 61 with respect to the horizontal plane.

To be specific, the plate-like base 61 has, on its lower face, an adjustable leg 62 which enables adjustment of the inclination angle β on the horizontal plane. The base 61 has, on its upper face, the pipe line 11C meandering along the upper face.

When the inclination angle β is 0 (zero) degrees, the inclination angle α of the pipe line 11C is also 0 (zero) degrees. As the inclination angle β increases, the inclination angle α of the pipe line 11C also increases. In such a case, an amount of the change in the inclination angle α is small as compared to an amount of the change in the inclination angle β. Therefore, the inclination angle α can be adjusted precisely.

A high-voltage electrode 12Ca and a ground electrode 12Cb are disposed to face each other with the pipe line 11C interposed therebetween. The high-voltage electrode 12Ca is disposed above and along the pipe line 11C. The ground electrode 12Cb has a rectangular plate-like shape and a size sufficient to cover the entirety of the pipe line 11C. The ground electrode 12Cb is disposed below the pipe line 11C.

Cooling pipe lines 13Ca and 13Cb are disposed to contact the high-voltage electrode 12Ca and the ground electrode 12Cb, respectively.

The structures and functions of the other parts of the sterilization liquid production apparatus 1C according to the third embodiment are similar to those of the sterilization liquid production apparatus 1 according to the first embodiment. Accordingly, description of the points common to the first embodiment shall be omitted.

According to the plasma treatment mechanism PKC of the third embodiment, the pipe line 11C can be lengthened even in a small installation area. This enables the plasma treatment to be applied more efficiently. Further, the inclination angle α of the pipe line 11C can be adjusted precisely by adjusting the inclination angle β with the adjustable leg 62.

In the foregoing embodiments, the shape and dimensions of the pipe lines 11, 11B, and 11C may not be limited to the foregoing examples, and may be variously changed. For example, the shape of a cross-section may be a semicircle, eclipse, rectangle, or polygon. Increase in dimensions of the pipe lines 11, 11B, and 11C enables the treated solution MLp to be generated more.

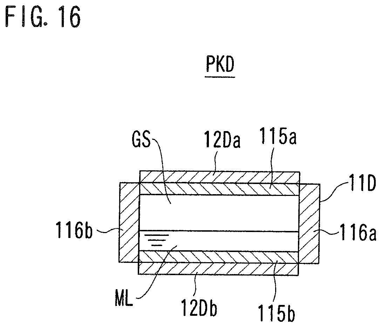

For example, a pipe line 11D having a rectangular cross-section is used as shown in a plasma treatment mechanism PKD of Fig. 16. The pipe line 11D is made to have a rectangular shape, so that the depth of the water ML flowing in the pipe line 11D is made constant with respect to the horizontal width direction. As a result, the plasma treatment can be applied to the water ML in a uniform manner. The large width of the pipe line 11D in the horizontal direction makes it possible to flow a large amount of the water ML having a large surface area. This enables efficient plasma treatment.

A dielectric material is used to form an upper wall portion 115a and a lower wall portion 115b of the pipe line 11D; thereby to generate dielectric barrier discharge inside the pipe line 11D. An insulating material having a low dielectric constant is used to form side wall portions 115c and 115d of the pipe line 11D. This prevents discharge and short-circuiting between the side wall portions 115c and 115d, and also prevents reduction in electric field.

A high-voltage electrode 12Da and a ground electrode 12Db are formed to have a plate-like cross-section and a band-like shape in the length direction along the upper wall portion 115a or the lower wall portion 115b of the pipe line 11D.

In order to cool the high-voltage electrode 12Da and the ground electrode 12Db of the sterilization liquid production apparatus 1E, a cooling pipe line having an appropriate shape is provided.

The use of the plasma treatment mechanism PKD enables mass production of the treated solution MLp.

The pipe line 11D may be formed to have a spiral shape. In such a case, the water ML is supplied from the upper end of the spiral, and the treated solution MLp is discharged from the lower end thereof.

### [Fourth Embodiment]

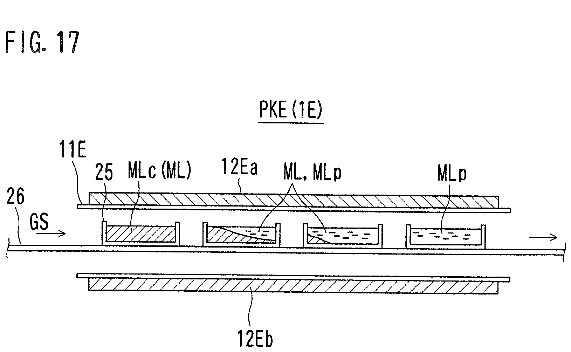

Fig. 17 schematically shows a structure of a plasma treatment mechanism PKE of a sterilization liquid production apparatus 1E according to a further embodiment of the present disclosure.

With the sterilization liquid production apparatus 1E shown in Fig. 17, water ML contained in a vessel 25 made of synthetic resin is frozen to ice KLc. As discussed above, a pH value of the water ML is adjusted to an appropriate value. The vessels 25 each of which contains the ice KLC therein are conveyed in order, from the inlet of the pipe line 11E, by a conveyor (conveyor belt) 26 made of synthetic resin. The pipe line 11E has a rectangular cross-section which allows the conveyor 26 and the vessel 25 to pass therein. Nitrogen is supplied into the pipe line 11E. Dielectric barrier discharge is generated between the high-voltage electrode 12Ea to which a high voltage is applied and the ground electrode 12Eb. The ice KLc in each of the vessels 25 is exposed to plasma PM generated by the dielectric barrier discharge. When the ice KLc is exposed to the plasma PM, the ice melts gradually from the surface thereof with the heat of the plasma PM, so that the ice KLC returns to the liquid ML. The liquid ML is also successively exposed to the plasma PM for plasma treatment. Thereby, active species are diffused in the liquid ML, which produces the plasma-treated solution MLp. The ice KLc in the vessel 25 melts completely and returns to the treated solution MLp. After that, the vessel 25 containing the treated solution MLp therein is conveyed from the outlet of the pipe line 11E. In other words, the vessel 25 conveyed from the pipe line 11E contains the treated solution MLp as a liquid for sterilization use.

According to the sterilization liquid production apparatus 1E, the treated solution MLp can be generated at a temperature of 0 (zero) degrees or so. Therefore, the solid ice MS having a high concentration of active species can be generated successively in an efficient manner. In addition, the device may be simplified because the ice KLc functions as a cooling device.

The vessel 25 containing the treated solution MLp therein may be cooled by using the appropriate base as descried earlier. The opening of the vessel 25 may be sealed with a lid, which enables the treated solution MLp in the vessel 25 to be delivered to a location far from the installation site of the sterilization liquid production apparatus 1E.

Alternatively, the vessel 25 conveyed from the pipe line 11E may be cooled, and the treated solution MLp contained therein may be frozen rapidly to make a solid ice. The treated solution MLp can be stored for a longer period of time by freezing the treated solution MLp into a solid ice. In such a case, the process starting from the generation of the treated solution MLp to the generation of the solid ice MS may be performed in one identical vessel 25. The solid ice may be thawed at a place where sterilization treatment is applied, and the resultant may be applied to an object.

With the sterilization liquid production apparatus 1E, the size of the vessel 25, pipe line 11E, high-voltage electrode 12Ea, ground electrode 12Eb and so on, and the speed of the conveyor 26 are preferably adjusted so that ice KLc melts smoothly and the plasma treatment is applied to the water ML smoothly.

Instead of conveying the vessels 25 by the conveyor 26, another arrangement is possible in which the vessels 25 are pushed in, one by one, from the inlet of the pipe line 11E, and the vessels 25 are pushed out, one by one, from the outlet of the pipe line 11E.

A variety of shapes, sizes, and materials of the vessel 25 and the pipe line 11E may be used.

### [Descriptions Using Flowchart]

The description goes on to a summary of a method for generating a liquid for sterilization use by means of the sterilization liquid production apparatus 1, 1B, or 1C with reference to a flowchart.

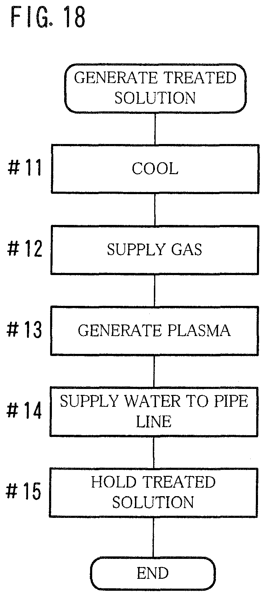

Referring to Fig. 18, the plasma treatment mechanism is cooled (Step #11), the gases GS are supplied (Step #12), dielectric barrier discharge is generated to generate plasma in the pipe line 11 (Step #13), the water ML is supplied (Step #14), and the treated solution MLp is put in the treated solution vessel 24 (Step #15).

The order of processes in Steps #11-#14 may be switched from one to another, or alternatively, may be concurrent with one another.

### [Other]

The sterilization liquid production apparatuses 1, 1B, 1C, and 1E according to the foregoing embodiments are capable of generating the treated solution MLp successively and efficiently.

The pipe line 11 is closed to the outside. Only water ML, nitrogen gas, and helium gas are present inside the pipe line 11, and no oxygen gas is present substantially. Therefore, no ozone is generated, and therefore, the treated solution MLp is not affected by ozone.

In the foregoing embodiments, the sizes and shapes of the high-voltage electrode 12a and the ground electrode 12b are not limited to the foregoing, and may be arbitrarily modified in various ways. For example, the high-voltage electrode 12a and the ground electrode 12b may be formed to have a shape along the surface of the pipe line 11, 11B, 11C, or 11E. In such a case, the high-voltage electrode 12a and the ground electrode 12b may be implemented by using a conductive tape, a copper foil, or a copper plate, for example, to attach the same to the surface of the pipe line 11, 11B, 11C, or 11E.

The layout of the high-voltage electrode 12a and the ground electrode 12b may differ from that in the foregoing examples. For example, the high-voltage electrode 12a may be disposed below the pipe line 11 and the ground electrode 12b may be disposed thereabove. Alternatively, the high-voltage electrode 12a and the ground electrode 12b may be laid out on the right and left of the pipe line 11.

In the foregoing embodiments, the sizes and shapes of the cooling pipe lines 13a and 13b are not limited to the examples, and may be arbitrarily modified in various ways. The cooling device RS may be an electronic cooling device using a Peltier element. In such a case, the Peltier element or the like may be attached to the high-voltage electrode 12a or the ground electrode 12b, or may be attached to the side face of the pipe line 11.

In the embodiments discussed above, the configurations of all or part of the pipe lines 11 and 11B-11E, the high-voltage electrode 12a, the ground electrode 12b, the cooling pipe lines 13a and 13b, the plasma treatment mechanisms PK, PKB, PKC, PKD, and PKE, the water vessel 21, the treated solution vessel 24, the vessel 25, the high voltage power supply 41, the cooler 51, and the sterilization liquid production devices 1, 1B, 1C, and 1E, structures, shapes, dimensions, quantities, materials, arrangements thereof, and so on may be arbitrarily modified in various ways if within the scope of the present invention.

Further, kinds, components, temperatures, pressures, speeds, and so on of the water ML or the gases GS may be arbitrarily selected if within the scope of the present invention, the scope of the present invention being defined and limited by the following appended claims.

## Claims

1. An apparatus (1) for producing liquid for sterilization use, comprising:
a pipe line (11);
a water supplying device (21, 22, 23) for supplying the pipe line with water (ML);
a gas supplying device (31, 32, 33, 34, 35) for supplying the pipe line with nitrogen gas;
a plasma generation device (PK) having a high-voltage electrode (12a) and a ground electrode (12b) which are provided outside the pipe line (11) to face each other with the pipe line (11) interposed therebetween and for applying a plasma treatment continuously to the water (ML) flowing in the pipe line (11) by generating dielectric barrier discharge between the high-voltage electrode (12a) and the ground electrode (12b);
a cooling device (RS) for cooling the water (ML) flowing in the pipe line (11), the cooling device (RS) comprising a cooler (51) and cooling medium pipe lines (52a, 52b);
a vessel (24) for holding the water flowing out of the pipe line as the liquid for sterilization use; wherein
the cooling device (RS) is configured to cool the water (ML) to a temperature of 10°C or lower,
wherein the plasma generation device (PK) is configured to apply the plasma treatment to generate a plasma-treated solution (MLp) in which superoxide anion radicals (O₂⁻•) or a precursor thereof is diffused in the water (ML) so as to sustain a microbicidal activity, such that the plasma treated solution (MLp) becomes said liquid for sterilisation use;
and wherein said apparatus for producing liquid for sterilisation use (1) further comprises
a pH adjustment device for adjusting a pH value of said water (ML), such that the plasma treated solution (MLp) in said vessel (24) has said pH value of 4.8 or lower.

2. The apparatus (1) according to claim 1, wherein the pipe line (11) is provided to have an inclination with respect to a horizontal plane, such that the water (ML) flows in the pipe line by gravity of the water due to inclination of the pipe line.

3. The apparatus (1) according to claim 2, wherein the pipe line (11) is made of a dielectric material, and
the plasma generation device (PK) is so arranged that the pipe line (11) functions as a dielectric for the dielectric barrier discharge.

4. The apparatus (1) according to claim 3, wherein each of the high-voltage electrode (12a) and the ground electrode (12b) has a rectangular cross-section, is disposed along the pipe line (11), and has a width corresponding to a width of the pipe line, and
the high-voltage electrode (12a) is disposed above the pipe line, and the ground electrode (12b) is disposed below the pipe line.

5. The apparatus (1) according to claim 4, wherein the cooling medium pipe lines (52a, 52b) are disposed to contact the high-voltage electrode (12a) and the ground electrode (12b).

6. The apparatus (1) according to claim 4 or 5, wherein the pipe line (11) has a circular cross-section, and the inside of the pipe line is filled with water, nitrogen gas and helium gas, such that no oxygen gas is present in said pipeline (11).

7. The apparatus (1) according to claim 3, wherein the ground electrode (12b) is formed to have a hollow portion (121) for the flow of a cooling medium (RB), and the ground electrode (12b) is a part of the cooling device (RS).

8. The apparatus (1) according to claim 2, wherein the pipe line (11) is provided to meander on a base (61) inclinable to the horizontal plane, and
the apparatus (1) is configured to adjust a speed of the water flowing in the pipe line (11) by varying an inclination angle of the base (61) with respect to the horizontal plane.

9. A method for producing liquid for sterilization use, comprising:
supplying a pipe line (11) with water (ML) and nitrogen gas; and
generating dielectric barrier discharge between a high-voltage electrode (12a) and a ground electrode (12b) which are provided outside the pipe line (11) to face each other with the pipe line interposed therebetween while water (ML) flowing in the pipe line is cooled directly or indirectly by a cooling device (RS) to have a temperature of 10°C or lower, and continuously making plasma generated by the dielectric barrier discharge contact with the water flowing in the pipe line to generate a plasma-treated solution in which superoxide anion radicals (O₂⁻•) or a precursor thereof is diffused in the water and a microbicidal activity is sustained, and holding the plasma-treated solution in a vessel as the liquid for sterilization use, wherein the pH of the water is adjusted such that said liquid for sterilisation use has a pH value of 4.8 or lower.

10. The method according to claim 9, wherein the pipe line (11) is provided to have an inclination with respect to a horizontal plane, and the water (ML) flows in the pipe line by gravity of the water due to inclination of the pipe line.

11. The method according to claim 9 or 10, comprising
adding freezing-point depressant to the water (ML) to be supplied to the pipe line (11) to lower a freezing point of the water, and
cooling the water by the cooling device (RS) to become 0°C or lower but not to be frozen.

12. The method according to any one of claims 9 through 11, wherein water (ML) to be supplied to the pipe line (11) is adjusted in advance to have a pH value of 4.8 or lower.

13. A method for producing liquid for sterilization use, comprising:
supplying a pipe line (11) with ice and nitrogen gas;
generating a plasma;
applying a plasma treatment by emitting said plasma to the ice from outside the pipe line (11)
melting the ice with said plasma so to obtain water (ML);
emitting the plasma to said water; and
generating a plasma-treated solution (MLp) in which superoxide anion radicals (O₂⁻•) or a precursor thereof is diffused in the water and a microbicidal activity is sustained through the plasma treatment, and holding and obtaining, in a vessel (24), the plasma-treated solution as the liquid for sterilization use.

14. The apparatus (1) according to claim 1 comprising a freezing device for freezing the plasma-treated solution (MLp) to make solid ice and storing the solid ice at a temperature of -18°C or lower.

## Patentansprüche

1. Vorrichtung (1) zur Herstellung von Flüssigkeit zur Benutzung bei Sterilisation, umfassend:
eine Rohrleitung (11);
eine Wasserzufuhreinrichtung (21, 22, 23) zum Versorgen der Rohrleitung mit Wasser (ML);
eine Gaszufuhreinrichtung (31, 32, 33, 34, 35) zum Versorgen der Rohrleitung mit Stickstoffgas;
eine Plasmaerzeugungseinrichtung (PK) mit einer Hochspannungselektrode (12a) und einer Masseelektrode (12b), die außerhalb der Rohrleitung (11) so vorgesehen sind, dass sie einander zugewandt sind, wobei die Rohrleitung (11) dazwischen angeordnet ist, und zum kontinuierlichen Vornehmen einer Plasmabehandlung des Wassers (ML), das in der Rohrleitung (11) fließt, durch Erzeugen einer stillen elektrischen Entladung zwischen der Hochspannungselektrode (12a) und der Masseelektrode (12b);
eine Kühleinrichtung (RS) zum Kühlen des Wassers (ML), das in der Rohrleitung (11) fließt, wobei die Kühleinrichtung (RS) einen Kühler (51) und Kühlmediumrohrleitungen (52a, 52b) umfasst;
einen Behälter (24) zum Aufnehmen des Wassers, das aus der Rohrleitung herausfließt, als die Flüssigkeit zur Benutzung bei Sterilisation;
wobei die Kühleinrichtung (RS) dazu ausgestaltet ist, das Wasser (ML) auf eine Temperatur von 10 °C oder niedriger zu kühlen,
wobei die Plasmaerzeugungseinrichtung (PK) dazu ausgestaltet ist, die Plasmabehandlung vorzunehmen, um eine plasmabehandelte Lösung (MLp) zu erzeugen, in der Superoxidanionenreste (O₂⁻•) oder ein Vorläufer derselben in dem Wasser (ML) so verteilt sind/ist, dass eine mikrobizide Wirkung aufrechterhalten wird, derart dass die plasmabehandelte Lösung (MLp) die Flüssigkeit zur Benutzung bei Sterilisation wird;
und wobei die Vorrichtung zur Herstellung von Flüssigkeit zur Benutzung bei Sterilisation (1) ferner eine pH-Wert-Einstelleinrichtung zum Einstellen eines pH-Werts des Wassers (ML) umfasst, derart dass die plasmabehandelte Lösung (MLp) in dem Behälter (24) den pH-Wert von 4,8 oder niedriger aufweist.

2. Vorrichtung (1) nach Anspruch 1, wobei die Rohrleitung (11) so vorgesehen ist, dass sie eine Neigung bezogen auf eine horizontale Ebene aufweist, derart dass das Wasser (ML) in der Rohrleitung durch die Schwerkraft des Wassers aufgrund der Neigung der Rohrleitung fließt.

3. Vorrichtung (1) nach Anspruch 2, wobei
die Rohrleitung (11) aus einem dielektrischen Material hergestellt ist und
die Plasmaerzeugungseinrichtung (PK) so angeordnet ist, dass die Rohrleitung (11) als ein Dielektrikum für die stille elektrische Entladung fungiert.

4. Vorrichtung (1) nach Anspruch 3, wobei
jede der Hochspannungselektrode (12a) und der Masseelektrode (12b) einen rechteckigen Querschnitt aufweist, entlang der Rohrleitung (11) angeordnet ist und eine Breite aufweist, die einer Breite der Rohrleitung entspricht, und
die Hochspannungselektrode (12a) über der Rohrleitung angeordnet ist und die Masseelektrode (12b) unter der Rohrleitung angeordnet ist.

5. Vorrichtung (1) nach Anspruch 4, wobei die Kühlmediumrohrleitungen (52a, 52b) so angeordnet sind, dass sie mit der Hochspannungselektrode (12a) und der Masseelektrode (12b) in Kontakt stehen.

6. Vorrichtung (1) nach Anspruch 4 oder 5, wobei die Rohrleitung (11) einen kreisförmigen Querschnitt aufweist und das Innere der Rohrleitung mit Wasser, Stickstoffgas und Heliumgas gefüllt ist, derart dass kein Sauerstoffgas in der Rohrleitung (11) vorhanden ist.

7. Vorrichtung (1) nach Anspruch 3, wobei die Masseelektrode (12b) so ausgebildet ist, dass sie einen hohlen Abschnitt (121) für das Strömen eines Kühlmediums (RB) aufweist, und die Masseelektrode (12b) ein Teil der Kühleinrichtung (RS) ist.

8. Vorrichtung (1) nach Anspruch 2, wobei
die Rohrleitung (11) so vorgesehen ist, dass sie auf einer Basis (61) mäandert, die gegenüber der horizontalen Ebene neigbar ist, und
die Vorrichtung (1) dazu ausgestaltet ist, eine Geschwindigkeit des Wassers, das in der Rohrleitung (11) fließt, durch Variieren eines Neigungswinkels der Basis (61) bezogen auf die horizontale Ebene einzustellen.

9. Verfahren zur Herstellung von Flüssigkeit zur Benutzung bei Sterilisation, umfassend:
Versorgen einer Rohrleitung (11) mit Wasser (ML) und Stickstoffgas; und
Erzeugen einer stillen elektrischen Entladung zwischen einer Hochspannungselektrode (12a) und einer Masseelektrode (12b), die außerhalb der Rohrleitung (11) so vorgesehen sind, dass sie einander zugewandt sind, wobei die Rohrleitung dazwischen angeordnet ist, während Wasser (ML), das in der Rohrleitung fließt, direkt oder indirekt durch eine Kühleinrichtung (RS) so gekühlt wird, dass es eine Temperatur von 10 °C oder niedriger aufweist, und kontinuierliches Bewirken, dass Plasma, das durch die stille elektrische Entladung erzeugt wird, mit dem Wasser in Kontakt steht, das in der Rohrleitung fließt, um eine plasmabehandelte Lösung zu erzeugen, in der Superoxidanionenreste (O₂⁻●) oder ein Vorläufer derselben in dem Wasser verteilt sind/ist und eine mikrobizide Wirkung aufrechterhalten wird, und Aufnehmen der plasmabehandelten Lösung in einem Behälter als die Flüssigkeit zur Benutzung bei Sterilisation, wobei der pH-Wert des Wassers derart eingestellt wird, dass die Flüssigkeit zur Benutzung bei Sterilisation einen pH-Wert von 4,8 oder niedriger aufweist.

10. Verfahren nach Anspruch 9, wobei die Rohrleitung (11) so vorgesehen ist, dass sie eine Neigung bezogen auf eine horizontale Ebene aufweist, und das Wasser (ML) in der Rohrleitung durch die Schwerkraft des Wassers aufgrund der Neigung der Rohrleitung fließt.

11. Verfahren nach Anspruch 9 oder 10, umfassend:
Zugeben von Gefrierpunkterniedriger zu dem Wasser (ML), das der Rohrleitung (11) zuzuführen ist, um einen Gefrierpunkt des Wassers abzusenken, und
Kühlen des Wassers durch die Kühleinrichtung (RS), so dass es 0 °C oder niedriger wird, aber nicht gefriert.

12. Verfahren nach einem der Ansprüche 9 bis 11, wobei Wasser (ML), das der Rohrleitung (11) zuzuführen ist, im Vorhinein so eingestellt wird, dass es einen pH-Wert von 4,8 oder niedriger aufweist.

13. Verfahren zur Herstellung von Flüssigkeit zur Benutzung bei Sterilisation, umfassend:
Versorgen einer Rohrleitung (11) mit Eis und Stickstoffgas;
Erzeugen eines Plasmas;
Vornehmen einer Plasmabehandlung durch Aussenden des Plasmas zu dem Eis von außerhalb der Rohrleitung (11) und dabei Schmelzen des Eises mit dem Plasma, um Wasser (ML) zu erhalten;
Aussenden des Plasmas zu dem Wasser; und
Erzeugen einer plasmabehandelten Lösung (MLp), in der Superoxidanionenreste (O₂⁻●) oder ein Vorläufer derselben in dem Wasser verteilt sind/ist und eine mikrobizide Wirkung durch die Plasmabehandlung aufrechterhalten wird, und Aufnehmen und Erhalten der plasmabehandelten Lösung als die Flüssigkeit zur Benutzung bei Sterilisation in einem Behälter (24).

14. Vorrichtung (1) nach Anspruch 1, die eine Gefriereinrichtung zum Gefrieren der plasmabehandelten Lösung (MLp), um festes Eis herzustellen, und Aufbewahren des festen Eises bei einer Temperatur von -18 °C oder niedriger umfasst.

## Revendications

1. Appareil (1) pour produire du liquide pour utilisation en stérilisation, comprenant :
un conduit (11) ;
un dispositif d'alimentation en eau (21, 22, 23) pour alimenter le conduit en eau (ML) ;
un dispositif d'alimentation en gaz (31, 32, 33, 34, 35) pour alimenter le conduit en azote gazeux ;
un dispositif de génération de plasma (PK) ayant une électrode à haute tension (12a) et une électrode reliée à la terre (12b) qui sont prévues à l'extérieur du conduit (11) de manière à se faire face l'une l'autre avec le conduit (11) intercalé entre elles et destiné à appliquer un traitement par plasma en continu à l'eau (ML) s'écoulant dans le conduit (11), par génération d'une décharge à barrière diélectrique entre l'électrode à haute tension (12a) et l'électrode reliée à la terre (12b) ;
un dispositif de refroidissement (RS) pour refroidir l'eau (ML) s'écoulant dans le conduit (11), le dispositif de refroidissement (RS) comprenant un refroidisseur (51) et des conduits de milieu refroidissant (52a, 52b) ;
un récipient (24) destiné à contenir l'eau sortant du conduit en tant que liquide pour utilisation en stérilisation ;
dans lequel le dispositif de refroidissement (RS) est configuré pour refroidir l'eau (ML) jusqu'à une température de 10 °C ou moins,
dans lequel le dispositif de génération de plasma (PK) est configuré pour appliquer le traitement par plasma pour générer une solution traitée par plasma (MLp) dans laquelle des radicaux d'anion superoxyde (O₂⁻●) ou un précurseur de ceux-ci est/sont diffusé(s) dans l'eau (ML) de sorte à assurer une activité microbicide, de telle sorte que la solution traitée par plasma (MLp) devient ledit liquide pour utilisation en stérilisation ;
et dans lequel ledit appareil pour produire du liquide pour utilisation en stérilisation (1) comprend en outre
un dispositif d'ajustement de pH pour ajuster une valeur de pH de ladite eau (ML), de telle sorte que la solution traitée par plasma (MLp) dans ledit récipient (24) a ladite valeur de pH de 4,8 ou moins.

2. Appareil (1) selon la revendication 1, dans lequel
le conduit (11) est prévu pour avoir une inclinaison par rapport à un plan horizontal, de telle sorte que l'eau (ML) s'écoule dans le conduit par gravité de l'eau en raison de l'inclinaison du conduit.

3. Appareil (1) selon la revendication 2, dans lequel
le conduit (11) est constitué d'un matériau diélectrique, et
le dispositif de génération de plasma (PK) est conçu de telle sorte que le conduit (11) fonctionne comme un diélectrique pour la décharge à barrière diélectrique.

4. Appareil (1) selon la revendication 3, dans lequel
chacune de l'électrode à haute tension (12a) et de l'électrode de mise à la terre (12b) a une section transversale rectangulaire, est disposée le long du conduit (11) et a une largeur correspondant à une largeur du conduit, et
l'électrode à haute tension (12a) est disposée au-dessus du conduit, et l'électrode de mise à la terre (12b) est disposée en dessous du conduit.

5. Appareil (1) selon la revendication 4, dans lequel les conduits de milieu de refroidissement (52a, 52b) sont disposés de manière à être en contact avec l'électrode à haute tension (12a) et l'électrode de mise à la terre (12b).

6. Appareil (1) selon la revendication 4 ou 5, dans lequel le conduit (11) a une section transversale circulaire, et l'intérieur du conduit est rempli d'eau, d'azote gazeux et d'hélium gazeux, de telle sorte qu'aucun oxygène gazeux n'est présent dans ledit conduit (11).

7. Appareil (1) selon la revendication 3, dans lequel l'électrode de mise à la terre (12b) est formée de manière à avoir une partie creuse (121) pour l'écoulement d'un milieu de refroidissement (RB), et l'électrode de mise à la terre (12b) fait partie du dispositif de refroidissement (RS) .

8. Appareil (1) selon la revendication 2, dans lequel
le conduit (11) est prévu pour serpenter sur une base (61) inclinable par rapport au plan horizontal, et
l'appareil (1) est configuré pour ajuster une vitesse de l'eau s'écoulant dans le conduit (11) en faisant varier un angle d'inclinaison de la base (61) par rapport au plan horizontal.

9. Procédé de production de liquide pour utilisation en stérilisation, comprenant :
l'alimentation d'un conduit (11) en eau (ML) et en azote gazeux ; et
la génération d'une décharge à barrière diélectrique entre une électrode à haute tension (12a) et une électrode de mise à la terre (12b) qui sont prévues à l'extérieur du conduit (11) de manière à se faire face l'une l'autre avec le conduit intercalé entre elles alors que l'eau (ML) s'écoulant dans le conduit est refroidie directement ou indirectement par un dispositif de refroidissement (RS) pour avoir une température de 10 °C ou moins, et la mise en contact en continu du plasma généré par la décharge à barrière diélectrique avec l'eau s'écoulant dans le conduit pour générer une solution traitée par plasma dans laquelle des radicaux d'anion superoxyde (O₂⁻●) ou un précurseur de ceux-ci est/sont diffusé(s) dans l'eau (ML) et une activité microbicide est assurée, et
le confinement de la solution traitée par plasma dans un récipient en tant que liquide pour utilisation en stérilisation, dans lequel le pH de l'eau est ajusté de telle sorte que ledit liquide pour utilisation en stérilisation a une valeur de pH de 4,8 ou moins.

10. Procédé selon la revendication 9, dans lequel le conduit (11) est prévu pour avoir une inclinaison par rapport à un plan horizontal, et l'eau (ML) s'écoule dans le conduit par gravité de l'eau en raison de l'inclinaison du conduit.

11. Procédé selon la revendication 9 ou 10, comprenant
l'ajout d'un réducteur de point de congélation à l'eau (ML) devant être fournie au conduit (11) pour abaisser un point de congélation de l'eau, et
le refroidissement de l'eau par le dispositif de refroidissement (RS) jusqu'à ce qu'elle soit de 0 °C ou moins, mais ne soit pas congelée.

12. Procédé selon l'une quelconque des revendications 9 à 11, dans lequel l'eau (ML) devant être fournie au conduit (11) est ajustée à l'avance pour avoir une valeur de pH de 4,8 ou moins.

13. Procédé de production de liquide pour utilisation en stérilisation, comprenant :
l'alimentation d'un conduit (11) en glace et en azote gazeux ;
la génération d'un plasma ;
l'application d'un traitement par plasma en émettant ledit plasma vers la glace depuis l'extérieur du conduit (11) ;
la fonte de la glace avec ledit plasma de sorte à obtenir de l'eau (ML) ;
l'émission du plasma vers ladite eau ; et
la génération d'une solution traitée par plasma (MLp) dans laquelle des radicaux d'anion superoxyde (O₂⁻●) ou un précurseur de ceux-ci est/sont diffusé(s) dans l'eau et une activité microbicide est assurée par le biais du traitement par plasma, et le confinement et l'obtention, dans un récipient (24), de la solution traitée par plasma en tant que liquide pour utilisation en stérilisation.

14. Appareil (1) selon la revendication 1, comprenant un dispositif de congélation pour congeler la solution traitée par plasma (MLp) pour rendre la glace solide et stocker la glace solide à une température de -18 °C ou moins.
